# EUROPÄISCHE PATENTSCHRIFT

(11) **EP 3 997 259 B1**
(45) Veröffentlichungstag und Bekanntmachung des Hinweises auf die Patenterteilung: **14.02.2024**
(21) Anmeldenummer: 20734535.6
(22) Anmeldetag: 24.06.2020
(51) Int. Cl.: C30B 15/04, C30B 15/20, C30B 15/30, C30B 29/06

(54) **VERFAHREN ZUM ZIEHEN EINES EINKRISTALLS AUS SILIZIUM GEMÄSS DER CZOCHRALSKI-METHODE**
METHOD FOR PULLING A SINGLE CRYSTAL OF SILICON IN ACCORDANCE WITH THE CZOCHRALSKI METHOD
PROCÉDÉ POUR TIRER UN MONOCRISTAL À PARTIR DE SILICIUM SELON LA MÉTHODE DE CZOCHRALSKI

(30) Priorität: 11.07.2019 DE 102019210254
(43) Veröffentlichungstag der Anmeldung: 18.05.2022
(73) Patentinhaber: Siltronic AG, 81677 München (DE)
(72) Erfinder: MANGELBERGER, Karl, 5122 Ach (AT); HEUWIESER, Walter, 84533 Stammham (DE); SKROBANEK, Michael, 09599 Freiberg (DE)
(86) Internationale Anmeldenummer: PCT/EP2020/067585
(87) Internationale Veröffentlichungsnummer: WO 2021/004784

(56) Entgegenhaltungen:
- US-A- 5 800 612
- US-A1- 2003 145 780
- US-A1- 2010 089 309

## Beschreibung

Gegenstand der Erfindung ist ein Verfahren zum Ziehen eines Einkristalls aus Silizium, der einen spezifischen Widerstand von nicht mehr als 20 mOhmcm aufweist, gemäß der Czochralski-Methode aus einer Schmelze.

### Stand der Technik / Probleme

Die Czochralski-Methode umfasst das Ziehen eines Einkristalls aus einer Schmelze, die in einem Tiegel enthalten ist. Der Einkristall wird an einem Keimkristall hängend aus der Schmelze gezogen. In der Regel wird zunächst ein Dünnhals (neck) am unteren Ende des Keimkristalls kristallisiert, damit Versetzungen zum Rand des Dünnhalses gelangen und auf diese Weise eliminiert werden.

US2003 0 209 186 A1 empfiehlt ein Verfahren, wonach der Dünnhals abschnittsweise zu ziehen ist und zwar zunächst einen Abschnitt mit einer Ziehgeschwindigkeit R1, dann einen weiteren Abschnitt mit einer mindestens 25 % geringeren Ziehgeschwindigkeit R2 und schließlich einen weiteren Abschnitt mit der Geschwindigkeit R1, wobei der Durchmesser eines jeden der Abschnitte mindestens ungefähr 5 mm beträgt.

In US5 800 612 ist ein Verfahren beschrieben, das vorsieht, die Bildung des Dünnhalses in Abschnitte zu gliedern und zu automatisieren.

Es ist bekannt, dass die Häufigkeit des Ereignisses, dass Versetzungen trotz des Ziehens eines Dünnhalses nicht vollständig eliminiert werden, ansteigt, wenn hoch dotierte Einkristalle aus Silizium gezogen werden, also Einkristalle, die einen vergleichsweise geringen spezifischen Widerstand haben, weil sie einen elektrisch aktiven Dotierstoff in vergleichsweise hoher Konzentration enthalten. Solche Versetzungen werden wegen ihrer Lage auch Zentrumsversetzungen genannt und häufig erst in Form von Zentrumsdefekten erkannt, nachdem der Einkristall gezogen wurde.

Um diesem Problem zu begegnen wird in US2010 0 089 309 A1 vorgeschlagen, die Ziehgeschwindigkeit beim Ziehen des Dünnhalses auf nicht mehr als 2 mm/min zu begrenzen, falls ein mit Bor dotierter Einkristall mit einem spezifischen Widerstand von nicht mehr als 1,5 mΩcm zu ziehen beabsichtigt ist.

In US2004 0 089 225 A1 ist beschrieben, dass die Konzentration von Germanium im Einkristall in bestimmten Grenzen an die Konzentration von Bor geknüpft werden sollte, falls beabsichtigt ist einen Einkristall aus Silizium zu ziehen, der eine vergleichsweise hohe Konzentration an Bor enthält und zusätzlich Germanium, um Probleme durch Fehlanpassungsversetzungen beim Abscheiden einer epitaktischen Schicht auf einer Halbleiterscheibe zu vermeiden, die von einem solchen Einkristall geschnitten wird.

Aufgabe der vorliegenden Erfindung ist es, die Häufigkeit des genannten Ereignisses weiter zu reduzieren und ohne dabei besonderen Beschränkungen unterworfen zu sein.

Die Aufgabe wird gelöst durch ein Verfahren zum Ziehen eines Einkristalls aus Silizium, der einen spezifischen Widerstand von nicht mehr als 20 mΩcm aufweist, gemäß der Czochralski-Methode aus einer Schmelze, umfassend das Ziehen eines ersten Abschnitts eines Dünnhalses mit einer ersten Ziehgeschwindigkeit, aufgrund derer sich der Durchmesser des ersten Abschnitts des Dünnhalses im Vergleich zum Durchmesser eines Keimkristalls mit einer Rate von nicht weniger als 0,3 mm pro mm Länge des Dünnhalses auf einen Zieldurchmesser von nicht mehr als 5 mm verjüngt;
das Ziehen eines zweiten Abschnitts eines Dünnhalses mit einer zweiten Ziehgeschwindigkeit von weniger als 0,2 mm/min über einen Zeitraum von nicht weniger als 3 min, ohne dass sich der Durchmesser des zweiten Abschnitts des Dünnhalses auf mehr als 5,5 mm erhöht; und
das Ziehen eines dritten Abschnitts des Dünnhalses mit einer dritten Ziehgeschwindigkeit von mehr als 2 mm/min.

Erfindungsgemäß wird zunächst der Durchmesser des Dünnhalses vom Durchmesser des Keimkristalls vergleichsweise schnell auf den Zieldurchmesser des zweiten Abschnitts verjüngt. Zu diesem Zweck wird der erste Abschnitt des Dünnhalses mit einer Ziehgeschwindigkeit gezogen, aufgrund derer sich der Durchmesser des Dünnhalses mit einer Rate von nicht weniger als 0,3 mm pro mm Länge des Dünnhalses verjüngt.

Der Keimkristall hat einen runden, quadratischen oder rechteckigen Querschnitt. Der Durchmesser beträgt vorzugsweise 10 bis 30 mm und bezeichnet im Fall von quadratischen oder rechteckigen Querschnitten die Länge der längsten Kante.

Des Weiteren muss nach dem Ziehen des ersten Abschnitts des Dünnhalses die Ziehgeschwindigkeit vorübergehend deutlich abgesenkt werden und gleichzeitig dafür gesorgt werden, dass sich aufgrund dessen der Durchmesser des Dünnhalses nicht wesentlich vergrößert. Eine Vergrößerung des Durchmessers auf nicht mehr als 5,5 mm kann als Vergrößerung angesehen werden, die noch nicht wesentlich ist. Um zu verhindern, dass der Durchmesser wegen des deutlichen Absenkens der Ziehgeschwindigkeit wesentlich größer wird, wird vorzugsweise die Heizleistung zum Erhitzen der Schmelze erhöht. Das Ziehen des zweiten Abschnitts des Dünnhalses mit deutlich abgesenkter Ziehgeschwindigkeit wird über einen Zeitraum von nicht weniger als 3 min, vorzugsweise über einen Zeitraum von nicht weniger als 5 min und nicht mehr als 50 min aufrechterhalten. Während dieses Zeitraums beträgt die Ziehgeschwindigkeit, mit der der zweite Abschnitt des Dünnhalses gezogen wird weniger als 0,2 mm/min. Vorzugsweise hat die Ziehgeschwindigkeit während des Ziehens des zweiten Abschnitts des Dünnhalses einen Wert im Bereich von 0,01 mm/min bis weniger als 0,2 mm/min.

Die Reglung des Ziehens des Dünnhalses umfasst vorzugsweise auch eine Überwachungsfunktion, die den automatischen Abbruch des Ziehvorgangs veranlasst, falls der als zulässig erachtete Durchmesser des zweiten Abschnitts des Dünnhalses überschritten wurde.

Nach dem Ziehen des zweiten Abschnitts des Dünnhalses wird die Ziehgeschwindigkeit auf einen Wert von mehr als 2 mm/min erhöht und ein dritter Abschnitt des Dünnhalses gezogen. Der dritte Abschnitt des Dünnhalses hat vorzugsweise einen Durchmesser von nicht weniger als 4 mm und nicht mehr als 7 mm und eine Länge von vorzugsweise nicht weniger als 100 mm und nicht mehr als 300 mm. Dementsprechend wird vorzugsweise auch die Heizleistung zum Erhitzen der Schmelze angepasst.

Das weitere Ziehen des Einkristalls aus Silizium wird in üblicher Weise fortgesetzt und zwar mit dem Ziehen eines konusförmigen Abschnitts, eines zylindrischen Abschnitts und eines Endkonus des Einkristalls. Vom zylindrischen Abschnitt des Einkristalls werden einkristalline Halbleiterscheiben aus Silizium abgeschnitten und weiterbearbeitet.

Vorzugsweise wird die Schmelze mit einem horizontalen Magnetfeld beaufschlagt, zumindest während des Ziehens des Dünnhalses, des Anfangskonus und des zylindrischen Abschnitts des Einkristalls.

Das vorstehend beschriebene Verfahren eignet sich besonders zur Herstellung von einkristallinen Halbleiterscheiben aus Silizium mit einem Durchmesser von mindestens 200 mm, insbesondere mit einem Durchmesser von mindestens 300 mm.

Die Wirksamkeit der Erfindung wurde getestet, indem kleine Testkristalle aus mit Bor hochdotiertem einkristallinem Silizium mit einem Durchmesser von 40 mm in einer Testreihe unter verschiedenen Bedingungen während der Phase des Dünnhalsziehens gezogen wurden. Von den Einkristallen wurden jeweils Testscheiben mit einem Durchmesser von 1 Zoll (etwa 25,4 mm) und einer Dicke von 1,8 mm geschnitten und mittels SIRD (Scanning Infra-Red Depolarization) auf Gitterspannungen hin untersucht. Wird erfindungsgemäß vorgegangen, sinkt der Nachweis von Zentrumsdefekten und damit die Wahrscheinlichkeit, einen Einkristall mit Versetzungen zu ziehen, auf unter 1 %.

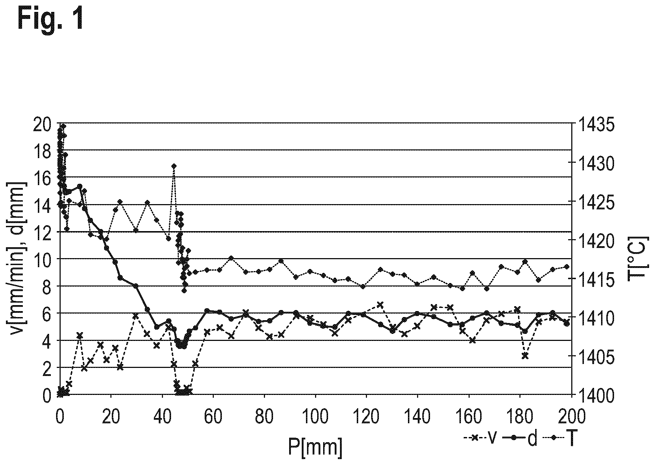

Drei anhängende Zeichnungen Fig.1, Fig.2 und Fig.3 zeigen über eine Länge P des Dünnhalses stellvertretend erfindungsgemäße Prozessbedingungen (Fig.1) und davon abweichende Prozessbedingungen (Fig.2 und Fig.3) der Testreihe. Die Zeichnungen enthalten Aussagen zur Ziehgeschwindigkeit v, zum Durchmesser d des Dünnhalses und zur Temperatur T der Schmelze. Die jeweiligen Testscheiben waren nur im Fall der Anwendung der erfindungsgemäßen Prozessbedingungen frei von Zentrumsdefekten.

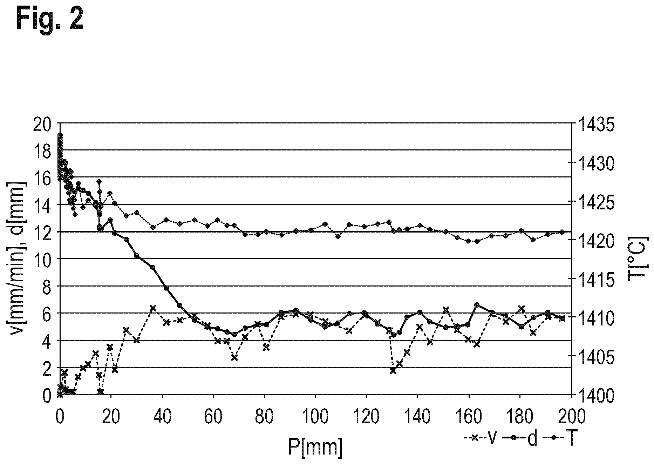

Im Fall der Prozessbedingungen gemäß Fig.2 wurde während des Ziehens des ersten Abschnitts des Dünnhalses die vorgesehene Rate der Verjüngung des Durchmessers unterschritten.

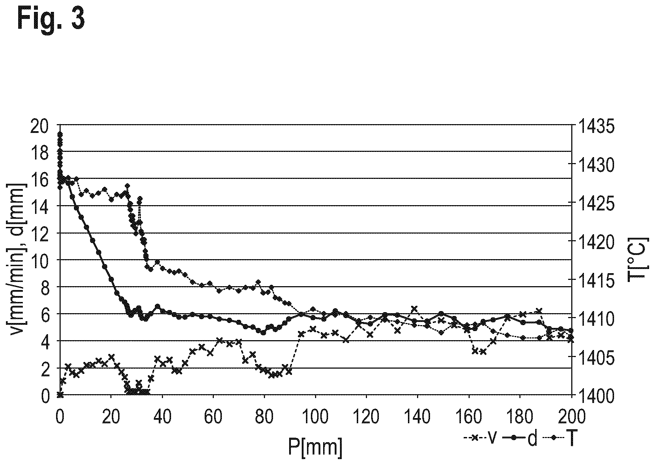

Im Fall der Prozessbedingungen gemäß Fig.3 wurde während des Ziehens des zweiten Abschnitts des Dünnhalses der als noch zulässig erachtete Durchmesser von 5,5 mm überschritten.

## Patentansprüche

1. Verfahren zum Ziehen eines Einkristalls aus Silizium, der einen spezifischen Widerstand von nicht mehr als 20 mΩcm aufweist, gemäß der Czochralski-Methode aus einer Schmelze, umfassend
das Ziehen eines ersten Abschnitts eines Dünnhalses mit einer ersten Ziehgeschwindigkeit, aufgrund derer sich der Durchmesser des ersten Abschnitts des Dünnhalses im Vergleich zum Durchmesser eines Keimkristalls mit einer Rate von nicht weniger als 0,3 mm pro mm Länge des Dünnhalses auf einen Zieldurchmesser von nicht mehr als 5 mm verjüngt;
das Ziehen eines zweiten Abschnitts eines Dünnhalses mit einer zweiten Ziehgeschwindigkeit von weniger als 0,2 mm/min über einen Zeitraum von nicht weniger als 3 min, ohne dass sich der Durchmesser des zweiten Abschnitts des Dünnhalses auf mehr als 5,5 mm erhöht; und
das Ziehen eines dritten Abschnitts des Dünnhalses mit einer dritten Ziehgeschwindigkeit von mehr als 2 mm/min.

2. Verfahren nach Anspruch 1, umfassend das Beaufschlagen der Schmelze mit einem horizontalen Magnetfeld.

3. Verfahren nach Anspruch 1 oder Anspruch 2, **dadurch gekennzeichnet, dass** der spezifische Widerstand durch Bor oder Arsen eingestellt wird, mit welchem die Schmelze dotiert wird.

4. Verfahren nach einem der Ansprüche 1 bis 3, **dadurch gekennzeichnet, dass** die Schmelze zusätzlich mit Germanium dotiert wird.

5. Verfahren nach einem der Ansprüche 1 bis 4, umfassend das Ziehen eines zylindrischen Abschnitts des Einkristalls und das Abtrennen von einkristallinen Halbleiterscheiben aus Silizium vom zylindrischen Abschnitt.

## Claims

1. Method for pulling a single silicon crystal having a resistivity of not more than 20 mΩcm by the Czochralski process from a melt, which comprises
pulling a first section of a neck at a first pulling velocity whereby the diameter of the first section of the neck, in comparison to the diameter of a seed crystal, tapers at a rate of not less than 0.3 mm per mm neck length to a target diameter of not more than 5 mm;
pulling a second section of a neck at a second pulling velocity of less than 0.2 mm/min over a period of not less than 3 min, without the diameter of the second section of the neck increasing to more than 5.5 mm; and
pulling a third section of the neck at a third pulling velocity of more than 2 mm/min.

2. Method according to Claim 1, comprising subjecting the melt to a horizontal magnetic field.

3. Method according to Claim 1 or Claim 2, **characterized in that** the resistivity is established by means of boron or arsenic with which the melt is doped.

4. Method according to any of Claims 1 to 3, **characterized in that** the melt is additionally doped with germanium.

5. Method according to any of Claims 1 to 4, which comprises pulling a cylindrical section of the single crystal and removing monocrystalline silicon semiconductor wafers from the cylindrical section.

## Revendications

1. Procédé pour le tirage d'un monocristal à base de silicium, qui présente une résistance spécifique n'excédant pas 20 mΩ.cm, selon la méthode de Czochralski à partir d'une masse fondue, comprenant
le tirage d'un premier segment d'un col mince à une première vitesse de tirage, en raison de laquelle le diamètre du premier segment du col mince se réduit en comparaison du diamètre d'un cristal germe à un diamètre cible n'excédant pas 5 mm, à une vitesse non inférieure à 0,3 mm par mm de longueur du col mince ; le tirage d'un deuxième segment d'un col mince à une deuxième vitesse de tirage de moins de 0,2 mm/min pendant une durée non inférieure à 3 min, sans que le diamètre du deuxième segment du col mince n'augmente à plus de 5,5 mm ; et
le tirage d'un troisième segment du col mince à une troisième vitesse de tirage de plus de 2 mm/min.

2. Procédé selon la revendication 1, comprenant l'exposition de la masse fondue à un champ magnétique horizontal.

3. Procédé selon la revendication 1 ou la revendication 2, **caractérisé en ce que** la résistance spécifique est ajustée par du bore ou de l'arsenic, avec lequel est dopée la masse fondue.

4. Procédé selon l'une des revendications 1 à 3, **caractérisé en ce que** la masse fondue est en outre dopée avec du germanium.

5. Procédé selon l'une des revendications 1 à 4, comprenant le tirage d'un segment cylindrique du monocristal et la séparation de galettes monocristallines de semi-conducteurs à base de silicium d'avec le segment cylindrique.
